Europäisches Patentamt

European Patent Office

Office européen des brevets

(11) Veröffentlichungsnummer: **0 238 710**
A2

# (12) EUROPÄISCHE PATENTANMELDUNG

(21) Anmeldenummer: 86112943.5

(51) Int. Cl.⁴: **H 03 B 21/02**

(22) Anmeldetag: **19.09.86**

(30) Priorität: 26.02.86 CH 767/86

(43) Veröffentlichungstag der Anmeldung: **30.09.87**
**Patentblatt 87/40**

(84) Benannte Vertragsstaaten: **CH DE FR GB IT LI NL SE**

(71) Anmelder: **SIEMENS-ALBIS AKTIENGESELLSCHAFT, EGA1/Verträge und Patente Postfach, CH-8047 Zürich (CH)**

(72) Erfinder: **Bächtiger, Rolf, Eggäckerstrasse 119, CH-8966 Oberwil-Lieli (CH)**

(54) Frequenzsynthetisierer.

(57) Der Frequenzsynthetisierer umfaßt eine Umschalteinrichtung (US), die eingangsseitig mit drei Signalen (S1, S2, S3), deren Frequenzen (f1, f2 bzw. f3) eine große Frequenzkonstanz aufweisen, beaufschlagt wird und ausgangsseitig drei durchgeschaltete Signale (Sx, Sy, Sz) abgibt, deren Frequenz jeweils gleich einer beliebigen unter den Eingangsfrequenzen ist. Dabei ist eine Mischerschaltung (M1, F1) vorgesehen, deren erster Eingang über einen Frequenzteiler (T1) mit einem der durchgeschalteten Signale (Sx) und deren zweiter Eingang mit einem anderen der durchgeschalteten Signale (Sy) beaufschlagt ist. Um Frequenzen f'omin .....f'omax zu erzeugen, deren relative Breite (f'omax − f'min)/f'min größer als die relative Breite (f4 − f1)/f1 der Eingangsfrequenzen f1 ....f4 ist, ist eine Mischereinheit (M3, F3) vorhanden, deren erster Eingang mit dem Ausgang der Mischerschaltung (M1, F1) verbunden und deren zweiter Eingang mit einem weiteren, über einen Frequenzvervielfacher (V) geführten durchgeschalteten Signal (Su) beaufschlagt ist.

0238710

Unser Zeichen

86P9802

Frequenzsynthetisierer

Die vorliegende Erfindung betrifft einen Frequenzsynthetisierer nach dem Oberbegriff des Patentanspruches 1.

Aus den IEEE Transactions on Microwave Theory and Techniques, Vol. MTT-30, No. 5, Mai 1982, S. 686-693, insbesondere Fig. 9, ist eine Anordnung zur Frequenzsynthese bekannt, bei der verschiedene, von einem Hauptoszillator abgeleitete Frequenzen miteinander kombiniert werden. Zu diesem Zweck ist eine Anzahl hintereinandergeschalteter Mischstufen vorgesehen, die je einen Mischer mit einem vorgeschalteten Frequenzteiler benutzen, um zwei von diesen Frequenzen wahlweise zu kombinieren, indem das Ausgangssignal des Mischers jeweils zur nächsten Stufe weitergeleitet wird. Damit können Ausgangssignale mit ausgezeichneter Kurz- und Langzeitstabilität geliefert werden, die zudem eine hohe Frequenzumschaltungsgeschwindigkeit aufweisen.

Eine solche Anordnung erweist sich jedoch als nachteilig im Hinblick auf eine Optimierung der Dämpfung der Nebenfrequenzen bei einem gegebenen Abstand der Nebenfrequenzen von der Nutzfrequenz.

Der Erfindung liegt daher die Aufgabe zugrunde, bei einer solchen Anordnung günstige Abstände der Nebenfrequenzen von der Nutzfrequenz zu erreichen und gleichzeitig die Dämpfung dieser Nebenfrequenzen zu verbessern.

Diese Aufgabe wird durch die im kennzeichnenden Teil des Patentanspruches 1 dargelegten Massnahmen gelöst. Vorteilhafte Ausgestaltungen der Erfindung sind in weiteren Ansprüchen angegeben.

Die Erfindung wird nachfolgend anhand einer Zeichnung beispielsweise näher erörtert. Es zeigt:

Fig. 1 das Blockschaltbild einer ersten Ausführung eines Frequenzsynthetisierers nach der Erfindung,

Fig. 2 das Blockschaltbild einer zweiten Ausführung eines erfindungsgemässen Frequenzsynthetisierers.

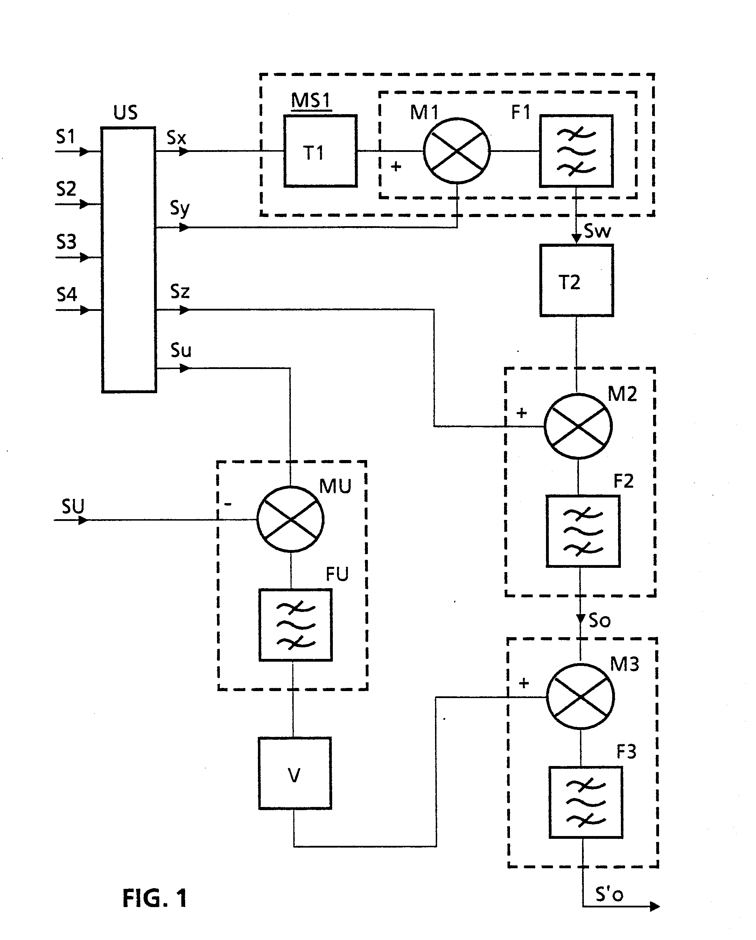

Der Frequenzsynthetisierer nach Fig. 1 umfasst eine Umschalteinrichtung US, zwei Frequenzteiler T1, T2 und zwei Mischer M1, M2, denen je ein Filter F1 bzw. F2 nachgeschaltet ist. Die Umschalteinrichtung US weist vier Eingänge für je ein Signal S1, S2, S3, S4 der Frequenz f1, f2, f3 bzw. f4 und drei Ausgänge für je ein Signal Sx, Sy, Sz der Frequenz fx, fy bzw. fz auf. Das Signal Sx wird über den Frequenzteiler T1 geführt und im Mischer M1 mit dem Signal Sy gemischt. Das Ausgangssignal Sw des Filters F1 wird über den Frequenzteiler T2 geführt und im Mischer M2 mit dem Signal Sz gemischt, wobei ein Frequenzteiler, ein Mischer und ein Filter jeweils eine Mischstufe, z.B. MS1 in Fig. 1, bilden. Am Ausgang des Filters F2 erscheint ein Signal So der Frequenz fo, welches dem Nutzsignal bzw. der Frequenz eines Frequenzsynthetisierers nach dem Stand der Technik entspricht.

Der beschriebene Teil des Frequenzsynthetisierers nach Fig. 1 funktioniert folgendermassen:

Die Frequenzen f1, f2, f3, f4 sind so gewählt, dass die Beziehungen

$$f4 - f3 = f3 - f2 = f2 - f1 = fd$$

gelten. Die Umschalteinrichtung US ist derart ausgelegt, dass das Signal Sx wahlweise eines der Signale S1, S2, S3 oder S4 ist oder mindestens eine der Frequenzen f1, f2, f3 oder f4 aufweist. Entsprechendes gilt für die Signale Sy und Sz. Die Frequenz fo des Nutzsignals So am Ausgang des Filters F2 ist somit, wenn die Teiler durch n dividieren,

$$fo = fz + (fy + fx/n) / n .$$

Da aber die Bedingungen der Umschalteinrichtung

$$fx = f1 + i.fd \qquad \text{mit} \quad i = 0,1,2,3$$
$$fy = f1 + j.fd \qquad \text{mit} \quad j = 0,1,2,3$$
$$fz = f1 + k.fd \qquad \text{mit} \quad k = 0,1,2,3$$

gelten, ergibt sich

$$fo = f1 (n^2 + n + 1) / n^2 + fd (i + jn + kn^2)/n^2$$

und daraus

$$fomin = f1 (n^2 + n + 1) / n^2$$
$$fomax = (f1 + 3 \cdot fd) (n^2 + n + 1) / n^2$$

Die relative Breite des Ausgangsfrequenzbandes ist

$$Bro = (fomax - fomin) / fomin = 3 \cdot fd/f1$$
$$Bro = 3 \cdot fd/f1 = (f4 - f1) / f1 = Bri$$

worin Bri die relative Breite des Eingangsfrequenzbandes ist. In diesem Fall sind daher die relativen Breiten des Ausgangs- und des Eingangsfrequenzbandes gleich (f4 – f1)/ f1, so dass der Faktor p = Bro/Bri = 1 ist.

Der erfindungsgemässe Frequenzsynthetisierer nach Fig. 1 ist jedoch gegenüber einem bekannten Synthetisierer derart erweitert, dass die Umschalteinrichtung US ein zusätzliches Signal Su liefert, dessen Frequenz fu ebenfalls gleich einer der Frequenzen f1, f2, f3 oder f4 sein kann. Dabei wird in einem zusätzlichen Mischer MU das Signal Su mit einem weiteren Signal SU gemischt und über die Reihenschaltung eines Bandpassfilters F4 und eines Frequenzvervielfachers V dem Eingang eines weiteren Mischers M3 zugeführt, der dieses Signal mit dem Ausgangssignal So des Filters F2 mischt. Dem Mischer M3 ist ein Bandpassfilter F3 nachgeschaltet, dem das Nutzsignal So' der Frequenz fo' entnommen wird.

Der erweiterte Frequenzsynthetisierer nach Fig. 1 funktioniert folgendermassen:

Wenn die Teiler T1 und T2 durch n dividieren und der Vervielfacher V mit dem Faktor m multipliziert, ergibt sich für die Frequenz fo' der Wert

$$f'o = fz + fy / n + fx / n^2 + (fu – fU) \cdot m$$

und wegen der Bedingungen der Umschalteinrichtung

$$f'o = fo + (fu – fU) \cdot m .$$

In diesem Fall kann für fU/f1 ein beliebiger Wert kleiner als 1, beispielsweise gleich 1/2, gewählt werden. Mit diesem Wert ergibt sich für f'omin und f'omax

$$f'omin = fomin + m \cdot (f1) / 2$$

$$f'omax = fomax + m \cdot (2f4 – f1) / 2$$

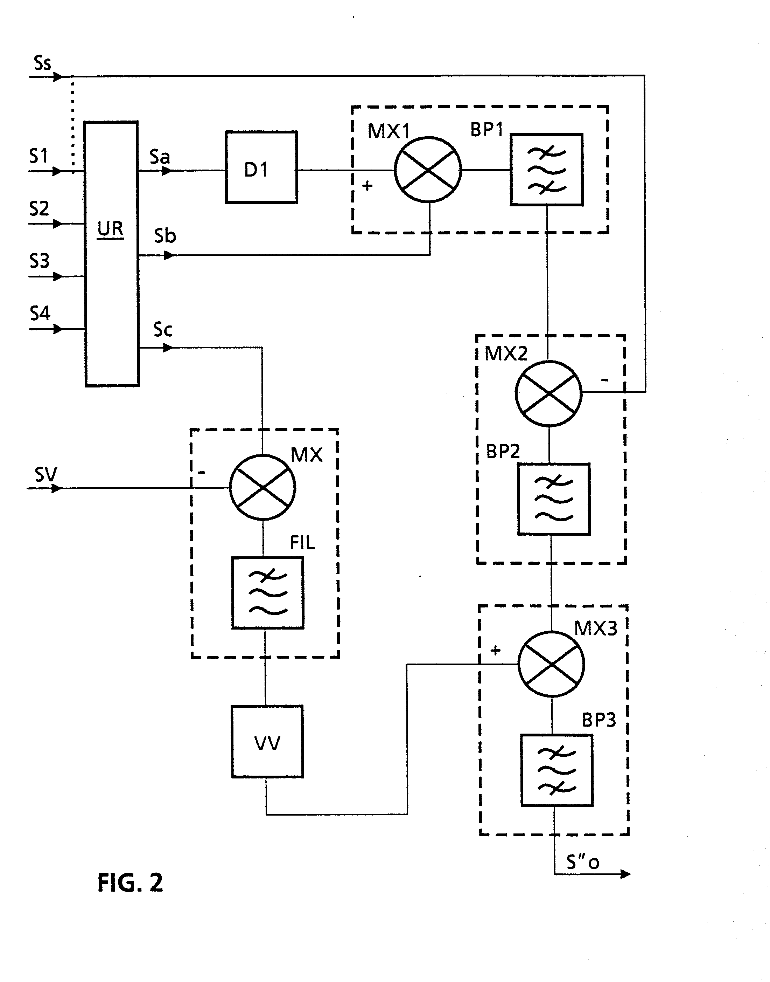

Daraus ergibt sich die relative Bandbreite des Ausgangsfrequenzbandes für die Schaltung nach Fig. 2 wie folgt

$$B'ro = (f'omax – f'omin) / f'omin = p' \cdot Bri$$

Nach einigen Umwandlungen resultiert

$$p'(n,m) = 2 (m \cdot n^2 + n^2 + n + 1) / (m \cdot n^2 + 2n^2 + 2n + 2)$$

Da der Faktor p' immer grösser als Eins ist, ergibt sich somit eine Erhöhung der relativen Ausgangsfrequenzbandbreite gegenüber der nicht erweiterten Schaltung nach Fig. 1.

Die allgemeine Formel für $n = 4$ ist

$$p'(4,m) = (16m + 21) / (8m + 21)$$

aus der sich für $m = 4$ der Wert

$$p'(4,4) = 85/53$$

ergibt.

Somit ergibt sich im Fall von Fig. 1 für $n = m = 4$ und $fU/F1 = 1/2$ eine Ausgangsfrequenzbandbreite, die um den Faktor 85/53 grösser ist als die Ausgangsfrequenzbandbreite der nicht erweiterten Schaltung nach Fig. 1.

Der Frequenzsynthetisierer nach Fig. 2 weist eine Umschalteinrichtung UR mit vier Eingängen für je ein Signal S1, S2, S3 und S4 der Frequenz f1, f2, f3 bzw. f4 und drei Ausgänge für je ein Signal Sa, Sb, Sc der Frequenz fa, fb bzw. fc auf. Das Signal Sa wird über einen Frequenzteiler D1 mit Teilungsverhältnis n : 1 dem ersten Eingang eines Mischers MX1 zugeführt, dessen zweiter Eingang mit dem Signal Sb beaufschlagt ist. In einem zweiten Mischer MX2 wird das über ein Bandpassfilter BP1 geführte Ausgangssignal des Mischers MX1 mit einem Signal Ss der Frequenz fs gemischt und das Mischprodukt über ein weiteres Bandpassfilter BP2 dem ersten Eingang eines dritten Mischers MX3 zugeführt. Das Signal Sc wird in einem vierten Mischer MX mit einem Signal SV der Frequenz f5 gemischt und das Mischsignal der Frequenz $(fc - f5)$ über die Reihenschaltung eines Filters FIL und eines Frequenzvervielfachers VV, der mit dem Faktor m multipliziert, dem zweiten Eingang des dritten Mischers MX3 zugeführt, dessen Ausgangssignal nach Durchlaufen eines weiteren Bandpassfilters BP3 das Ausgangssignal So" der Frequenz fo" darstellt.

Der Frequenzsynthetisierer nach Fig. 2 funktioniert somit derart, dass für die Frequenz fo" der Wert

$$fo" = m \cdot fc + fb + fa/n - (fs + m \cdot f5)$$

gilt. Daraus ergibt sich beispielsweise für $fs = f1$ :

$$f"omin = m \cdot f1 + f1/n - m \cdot f5$$
$$f"omax = m \cdot f4 + f4 + f4/n - m \cdot f5 - f1 .$$

Für die relative Ausgangs- bzw. Eingangsbandbreite gilt

$$B''ro = Bri \, (mn + n + 1)/(mn + 1 - mn \cdot f5/f1)$$

mit

$$Bri = (f4 - f1)/f1$$

und

$$p'' = B''ro/Bri = (mn + n + 1)/(mn + 1 - mn \cdot f5/f1)$$

In diesem Fall kann f5/f1 einen beliebigen Wert kleiner als 1 haben, beispielsweise 3/4.

Mit einem Frequenzsynthetisierer nach der Erfindung können somit Ausgangsfrequenzen f'omin ....... f'max erzeugt werden, deren relative Breite (f'omax – f'omin)/f'omin grösser als die relative Bandbreite (f4 – f1)/f1 der Eingangsfrequenzen f1 .....f4 ist. Werden jedoch geringere Breiten der Ausgangsfrequenzbänder gefordert, so vereinfacht sich der Filteraufwand beträchtlich.

Der Frequenzsynthetisierer nach der Erfindung kann selbstverständlich auch mit mehr als zwei oder drei kaskadierten Mischstufen, wie sie in den Figuren dargestellt sind, arbeiten.

0238710

# PATENTANSPRUECHE

1. Frequenzsynthesierer mit einer Umschalteinrichtung (US; UR), die eingangsseitig mit mindestens zwei Signalen (S1, S2), deren Frequenzen (f1 bzw. f2) eine relativ grosse Frequenzkonstanz aufweisen, beaufschlagt wird und ausgangsseitig mindestens zwei durchgeschaltete Signale (Sx, Sy; Sa, Sb) abgibt, deren Frequenz jeweils gleich einer beliebigen unter den Eingangsfrequenzen ist, und mit einer Mischerschaltung (M1, F1; MX1, BP1), deren erster Eingang über einen Frequenzteiler (T1; D1) mit einem der durchgeschalteten Signale (Sx) und deren zweiter Eingang mit einem anderen der durchgeschalteten Signale (Sy) beaufschlagt ist, d a d u r c h   g e k e n n - z e i c h n e t , dass eine ein Nutzsignal (S'o; S"o) liefernde Mischereinheit (M3, F3; MX3; BP3) vorhanden ist, deren erster Eingang mit dem Ausgang der Mischerschaltung (M1, F1; MX1, BP1) verbunden und deren zweiter Eingang mit einem weiteren, über einen Frequenzvervielfacher (V; VV) geführten durchgeschalteten Signal (Su, Sc) beaufschlagt ist.

2. Frequenzsynthetisierer nach Anspruch 1, d a d u r c h   g e k e n n z e i c h n e t , dass zwischen dem Ausgang der Mischerschaltung (M1, F1) und dem Eingang der Mischereinheit (M3, F3) die Reihenschaltung eines weiteren Frequenzteilers (T2) und einer weiteren Mischerschaltung (M2, F2) eingefügt ist, deren zweitem Eingang ein weiteres, von der Umschalteinrichtung (US) durchgeschaltetes Signal (Sz) zugeführt wird.

3. Frequenzsynthetisierer nach Anspruch 1 oder 2, d a d u r c h   g e k e n n - z e i c h n e t , dass zwischen dem Eingang des Frequenzvervielfachers (V; VV) und dem ihm zugeordneten Ausgang der Umschalteinrichtung (US; UR) eine Mischereinrichtung (MU, FU; MX, FIL) eingefügt ist, deren zweitem Eingang ein zusätzliches Signal (SU, SV) mit einer mindestens stufenweise konstanten Frequenz zugeführt wird.

4. Frequenzsynthetisierer nach einem der Ansprüche 1 bis 3, d a d u r c h   g e - k e n n z e i c h n e t , dass zwischen dem Ausgang einer Mischerschaltung (MX1, BP1) und dem Eingang der ihr nachgestalteten Mischschaltung oder Mischereinheit (MX3, BP3) eine zweite Mischereinrichtung (MX2, BP2) eingefügt ist, deren anderer Eingang mit einem weiteren Eingangssignal (Ss) beaufschlagt ist.

0238710

5. Frequenzsynthetisierer nach einem der Ansprüche 1 bis 4, d a d u r c h   g e - k e n n z e i c h n e t , dass die Frequenzteiler (T1, T2; D1) durch n = 4 teilen.

6. Frequenzsynthetisierer nach einem der Ansprüche 1 bis 5, d a d u r c h   g e - k e n n z e i c h n e t , dass der Frequenzvervielfacher (V; VV) mal n = 4 multipliziert.

7. Frequenzsynthetisierer nach einem der Ansprüche 3 bis 6, d a d u r c h   g e - k e n n z e i c h n e t ,  dass der zweite Eingang der ersten Mischereinrichtung (MU, FU; MX, FIL) mit einem Signal (SU; SV) beaufschlagt wird, dessen Frequenz (fu; F5) kleiner als die kleinste Eingangsfrequenz ist.

FIG. 1

**FIG. 2**